# EUROPEAN PATENT APPLICATION

(11) **EP 2 581 704 A1**
(43) Date of publication of application: **17.04.2013**
(21) Application number: 11185269.5
(22) Date of filing: 14.10.2011
(51) Int. Cl.: G01C 21/32, G09B 29/10, G06F 17/30

(54) **Method for compressing navigation map data**

(71) Applicant: Harman Becker Automotive Systems GmbH, 76307 Karlsbad (DE)
(72) Inventor: Kunath, Peter, 80999 München (DE); Heitmann, Marcus, 85386 Eching (DE); Baptist, Stefan, 80992 München (DE); Spindler, CC., 76135 Karlsruhe (DE); Mitrakis, Stavros, 85551 Kirchheim-Heimstetten (DE)
(74) Representative: Bertsch, Florian Oliver

(57) **Abstract**

The present invention relates to a method for generating compressed navigation map database from uncompressed navigation map data, the uncompressed navigation map data containing different building blocks of navigation data, each building block addressing a specific functional aspect of the navigation data, each block containing strings of data, the method comprising the steps of:
- determining, for each block of the uncompressed navigation map data, most frequent substrings of the block (21),
- storing, for each block, the determined most frequent substrings of the block in a seed block (22),
- replacing, for each block, in the strings the determined most frequent substrings stored in the seed block by a reference to the seed block thereby generating a compressed block for each block (23),
- storing, for each block, the compressed block and the seed block in order to generate the compressed navigation map database (24).

## Description

The invention relates to a method for generating compressed navigation map data from uncompressed navigation map data, to a compression module configured to generate the compressed navigation map data, to a method for providing navigation information to a user and to a navigation system providing navigation information to the user.

### Background

Navigation systems are known which perform functions such as route searches between two locations. Modern navigation systems may also provide additional functionalities, such as serving as a travel guide that outputs, upon demand, information on points of interest, etc. Some navigation systems may even include travel guide functions to output detailed explanations, m textual and/or multimedia form.

Furthermore, it has become common to display a three-dimensional view of the vehicle surrounding in which, in addition to the road, buildings etc. are displayed in a three-dimensional form. The three-dimensional representation should facilitate the finding of the correct way.

The different kinds of information provided to the user are all stored on a removable data storage unit, such as a CD ROM or DVD, or the information is provided on a hard disk.

In this context a need exists to minimize the storage space required by the navigation map data, the navigation map data including the different kinds of information used to inform the user of needed information.

### Summary

Accordingly, a need exists to provide a method allowing to efficiently reduce the storage space needed for storing the navigation map data.

This need is met by the features of the independent claims. In the dependent claims further embodiments are described.

According to a first aspect of the invention, a method for generating a compressed navigation map database from uncompressed navigation map data is provided. The uncompressed navigation data contains different building blocks of navigation data, each building block addressing a specific functional aspect of the navigation data and each building block containing byte sequences or strings of data. For the different building blocks of the uncompressed navigation map data most frequent substrings contained in the building blocks are determined. Furthermore, for the building blocks, the determined most frequent substrings of the building blocks are stored in at least one seed block. Furthermore, in the building blocks, the determined most frequent substrings stored in said at least one seed block are replaced in the strings by reference to said at least one seed block thereby generating compressed blocks. Furthermore, the compressed blocks and said at least one seed block are stored in order to generate the compressed navigation map database.

All navigational data is regarded as belonging to one of the building blocks, each building block describing a predefined functional aspect of the navigation data, e.g. a functional block is a route building block, a name building block. It should be understood that the navigation map data are further divided into different geographical regions and that the data may additionally be partitioned into different levels of detail. In the context of the present invention, however, the separation into functional blocks is discussed, each functional building block describing a different aspect used in a navigation system to provide an output to the user, e.g. a driving recommendation. By way of example the route building block provides the features for a routing calculation, the name building block containing the names of the streets shown on a map. In each building block the data are stored in strings and depending on the content of a block the string may be a street name or may provide color information for an image. By determining in the building blocks the most frequent substrings that are present in each block, it is possible to combine the most frequent substrings in said at least one seed block and to include, in the building blocks, instead of the most frequent substring, a reference to said at least one seed block. In this way a compressed block is obtained needing less storage capacity than the uncompressed navigation map data. It is clear from the above said that the compression degree depends on the number of most frequent substrings stored in the seed block and which are not contained any more in the compressed blocks, but which are replaced by the reference to the seed block.

In one embodiment it is possible that the most frequent substrings of a plurality of building blocks are stored in one seed block. This means that in one seed block the most frequent substrings of two or more building blocks may be contained. In another embodiment, it is however possible that a seed block containing the most frequent substrings is determined for each building block. In this embodiment for each building block, a seed block and a compressed block exist, whereas in the embodiment for each building block a compressed block exists but not necessarily one seed block for each compressed block.

Furthermore it is possible that each building block is separated in several parts before compression, wherein the most frequent substrings are determined for each part of a building block. The most frequent substrings of the different parts of a building block can then be stored in a single seed block.

Preferably the replaced reference contains an offset information and a length information, the offset information indicating where in the seed block the replaced most frequent substring is located. The length information provides the information about the length of the replaced most frequent substring. The reference with the offset information and the length information may be necessary when the compressed navigation map data should be used again by a navigation system. For generating the full information, the reference is replaced by the most frequent substring stored in the seed block again. For this replacement the information is used where in the seed block the corresponding replaced most frequent substring is stored. Additionally, the information is used how long the replaced most frequent substring is.

One possibility to determine the most frequent substrings of a block is to generate a prefix tree of the strings contained in a block and to determine the most frequent substrings in the prefix tree. In a prefix tree the position of a string in the tree defines the strings it is associated with. All the decendents of a node have a common prefix of a string associated with that node. When frequency values are associated with each node, it is easily possible to determine the most frequent substrings of a block.

The uncompressed navigation map data can contain different blocks, the route building block, the name building block, a traffic information building block, a 3D object building block, a junction view building block, or a digital terrain building block.

The invention furthermore relates to a compression module configured to generate the compressed navigation map data, the module comprising the first database containing the uncompressed navigation map data, the uncompressed navigation map data containing the different building blocks of the navigation data, each building block addressing a specific functional aspect of the navigation map data and each block containing strings of data. Furthermore, a second database is provided in the compression module and a processing unit configured to determine the compressed blocks and said at least one seed block as mentioned above.

The invention furthermore relates to a navigation system providing navigation information to the user, the navigation system comprising a storage unit containing compressed navigation map data, the compressed navigation map data containing different building blocks of navigation map data and each building block addresses a specific functional aspect of the navigation map data. The compressed navigation data contain at least one seed block and compressed blocks, said at least one seed block containing the most frequent substrings of the compressed blocks, wherein in the compressed blocks the determined most frequent substrings stored in said at least one seed block are replaced by a reference to said at least one seed block. Furthermore, the navigation system comprises an information unit providing navigation information to the user. By way of example the navigation information may be a visual output in 2D or 3D. The navigation system furthermore comprises a decompression unit configured to generate uncompressed navigation map data from the compressed navigation map data. The decompression unit accesses, for each building block, the compressed block and said at least one seed block and replaces the references contained in the compressed block by the corresponding most frequent substring of said at least one seed block in order to generate the uncompressed navigation map data. The decompression unit is furthermore configured to generate the navigation information based on the uncompressed navigation map data, the information unit using the uncompressed navigation map data to provide the navigation information to the user.

In one embodiment, for the decompression, the seed block is used as a virtual prefix for compression and decompression to simplify the compression and decompression algorithm. Normally, without the seed block of each block, the decompression is not possible. This also provides a light weight encryption of the navigation map data if the seed block is stored separately from the compressed blocks as the use of the navigation map data is not possible when for the compressed blocks the seed block is not provided. The invention furthermore provides a method for providing the navigation information to the user, wherein the uncompressed navigation map data are generated from the compressed navigation data, wherein the uncompressed navigation data are generated by accessing, for each block, the compressed blocks and said at least one seed block and by replacing the references contained in the compressed blocks by the corresponding most frequent substrings stored in said at least one seed block. The navigation information for the user is then generated based on the uncompressed navigation map data and the navigation information is provided to the user based on the uncompressed navigation map data.

### Brief Description of the Drawings

The foregoing and other features and embodiments will become more apparent from the following detailed description of embodiments when read in conjunction with the accompanying drawings. In the drawings,
Fig. 1 is a schematic view of a compression module configured to generate compressed navigation map data,
Fig. 2 is a flowchart containing the steps carried out for generating the compressed map navigation data,
Fig. 3 is a schematic view of a navigation system using the compressed navigation map data generated with the system of Fig. 1, and
Fig. 4 is a flowchart comprising the steps carried out for decompressing the compressed navigation map data before use.

### Detailed Description

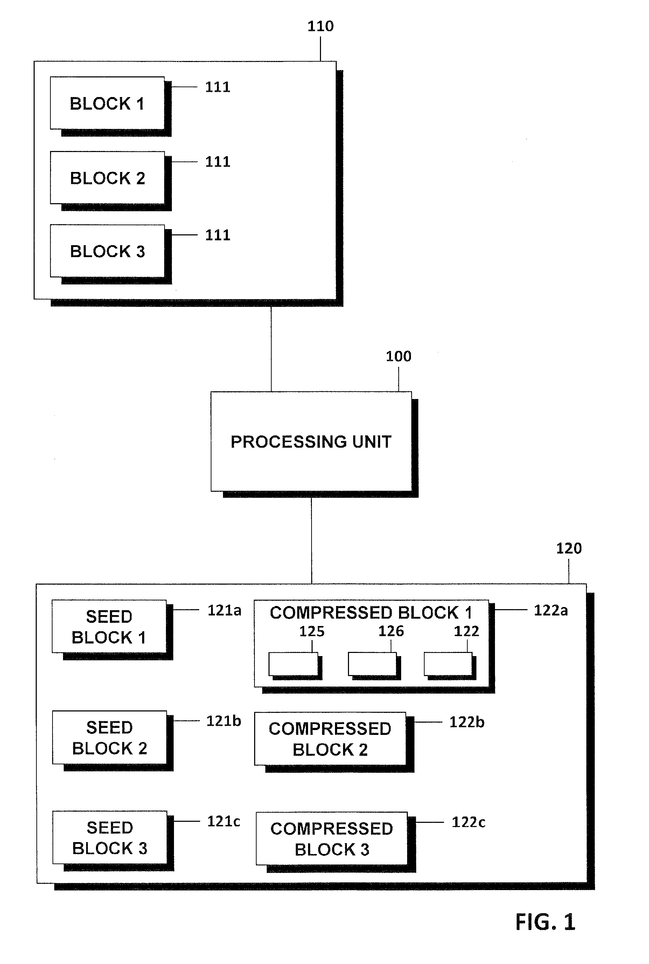

In Fig. 1 a schematic view of a compression module is shown which is able to generate compressed navigation map data from uncompressed navigation map data. The compression module comprises a first database 110 in which the different blocks of data 111 are stored. The map data stored in database 110 cover a certain geographical area. Furthermore, the navigation map data may be divided into different geographical regions, e.g. by dividing the geographical area into tiles. In the embodiment shown in Fig. 1 the separation into different geographical regions is not reflected by the embodiment shown. In the embodiment shown the separation of the navigation map data is carried out in view of the functional aspect of the map data. By way of example the first block shown in Fig. 1 may be a routing building block, the routing building block grouping together the features of the map data that are used for routing applications. The routing building block may contain a representation of the road network to be used for calculating routes. The second building block shown in Fig. 1 may be a name building block providing inter alia the names to the different objects shown on the map. Building block 3 shown in Fig. 1 may be a map display building block grouping together the features for map display application. It may contain the features necessary for providing a two-dimensional map together with their geometrical data. It should be understood that many more building blocks may be provided in the database 110, e.g. a traffic information building block, a PoI (Point of Interest) building block, a speech building block, a 3D objects building block, etc. A processing unit 100 accesses the first database and processes each of the blocks 111 in such a way that it precalculates the most frequent substrings contained in each block. The pieces of information stored in the blocks are strings. The processing unit will identify a number of most frequent substrings in each block. The number of most frequent substrings of a block may depend on the number of strings contained in each block and the type of data may e.g. vary between 100 and around 5000. The most frequent substring may be determined by generating, for each block, a prefix tree, and by identifying in this prefix tree the most frequent substrings.

The more substrings are identified as most frequent substrings to be substituted, the higher the compression rate will be. The processing unit 100 will now replace the determined most frequent substrings which occur in the different blocks 111 by references to a block named seed block in which the determined most frequent substrings are stored. This seed block with the most frequent substrings can play the role of a (virtual) prefix of the data to be compressed. The processing unit stores the compressed data in a second database. As shown in Fig. 1, for block 111 a seed block 121a comprising the most frequent substrings of block 1 is generated and the compressed block 122a in which the most frequent substrings contained in the seed block 121a are replaced by a reference to the seed block 121a. The reference furthermore contains an offset information indicating at which position within the seed block the omitted substring is stored. Furthermore, the reference contains a length information indicating the length of the replaced substrings. Furthermore, for block 2 of database 110 a seed block 121b is generated and a compressed block 122b. Seed block 121c comprises the most frequent substrings of block 3 and the compressed block 122c comprises the other non-replaced strings together with the references to the seed block.

In the embodiment shown compressed navigation map data are generated for each of the building blocks contained in the first storage unit 110.

However, it should be understood that the compressed block and the seed block are not necessarily generated for each of the blocks contained in database 110. By way of example if one of the blocks 111 of the database 110 is much smaller in size compared to the other blocks, the compression of such a block may be omitted.

In the embodiment shown in Fig. 1, one seed block is generated for each building block. However, it is also possible that the most frequent substrings of two or more building blocks are stored in a single seed block. In this embodiment, one seed block such as seed block 121a would comprise the most frequent substrings of compressed block 1 and compressed block 2.

Additionally it is possible that the blocks 111, before compression, are separated into different parts wherein the most frequent substrings are determined for each of the different parts of a building block so that for each compressed block compressed parts are generated such as part 125, 126 and 127 in Fig. 1. In this embodiment, the most frequent substrings of the different compressed parts 125-127 are stored in one seed block. The separation for compressed block in different compressed parts may be combined with embodiment where the most frequent substrings of more than one building block are stored in a single seed block. Thus, in this embodiment, the compressed parts of compressed block 1 and e.g. of the compressed parts of compressed block 2 would be stored in a single seed block. However, it is also possible that for each compressed block containing the compressed parts a seed block is generated.

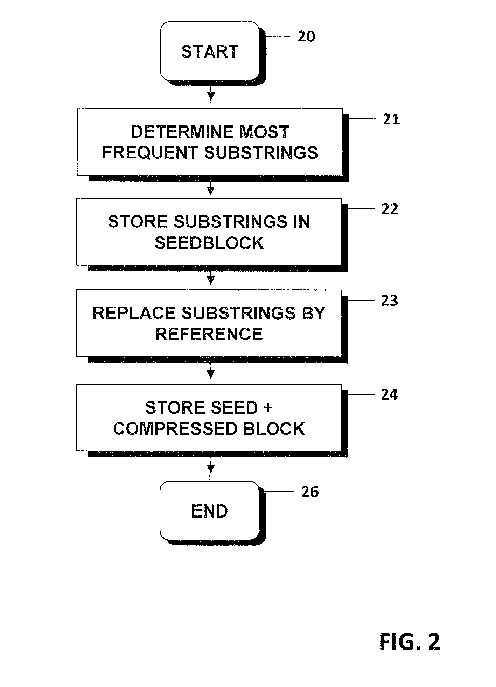

In Fig. 2 the steps carried out for generating the compressed navigation map data are summarized. The method starts in step 20 and in step 21 the most frequent substrings are determined for the strings contained in a block. In the next step 22 the most frequent substrings determined in step 21 are stored and grouped together in a seed block. Furthermore, when the number of substrings to be stored in the seed block is determined, these substrings are replaced in the block by the reference to the seed block (step 23). In step 24 the seed block and the compressed block are then stored. The method ends on step 25.

In the embodiment shown in Fig. 1 the first database 110 and the second database 120 are shown as separate entities. It should be understood that the first database and the second database may be represented by a single physical storage unit, so that the uncompressed blocks 111 are stored on the same physical storage unit as the corresponding compressed data.

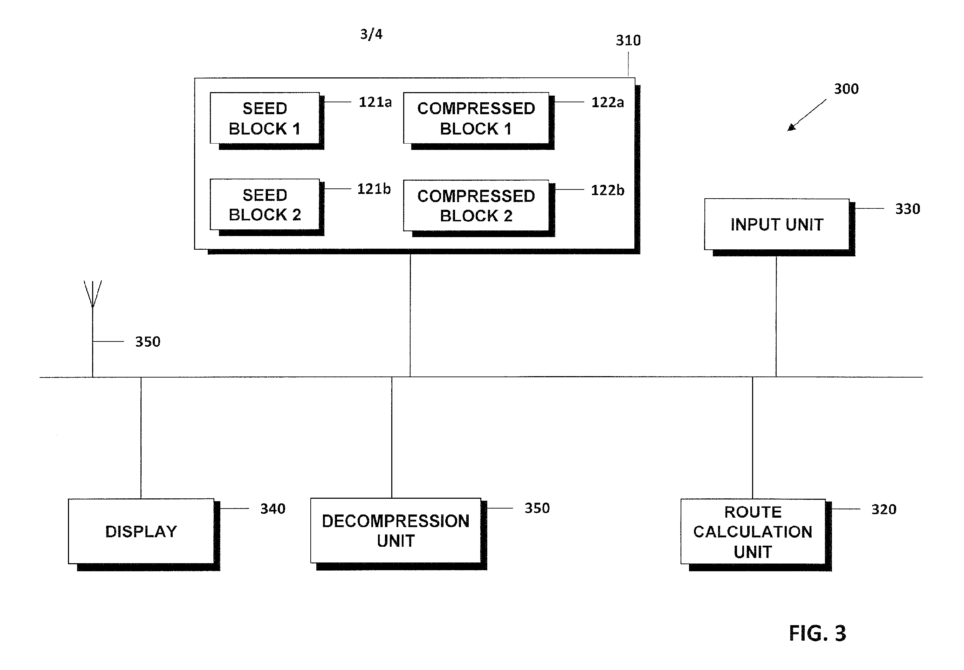

The compressed navigation map data stored in the storage unit 120 can be used by a navigation system shown in Fig. 3. The navigation system 300 shown in Fig. 3 comprises a storage unit 310 in which the compressed navigation map data with the seed blocks 121 and the corresponding compressed blocks 122 are stored. The data stored in database 310 can correspond to the data stored in database 120 of Fig. 1. The database 310 may comprise anyone or any combination of various types of storage or memory media, such as random access memory, flash memory or a hard drive, but also a removable memory, such as a compact disk, a DVD, a memory card or the like. The navigation system furthermore contains a route calculation unit 320 which is configured to calculate the fastest or shortest route from a first location to a second location. A user can control the functioning of the navigation system via input unit 330. The input unit may contain haptical devices such as buttons that can be pressed or turned. The input unit can furthermore contain a speech recognition module allowing to control the functioning of the navigation system using speech commands. The information calculated by the route calculation unit can be displayed on a display 340. Furthermore, driving recommendations may also be output using voice commands. An antenna 350 receiving satellite signals can be provided where signals are received that are used to calculate the position of the navigation system. The way how a navigation system calculates a route from a defined location to a desired destination is known in the art and will not be explained in detail. For the sake of clarity only the components of the navigation system are indicated which are helpful for the understanding of the invention. It should be understood that the navigation system may contain different modules and further features not indicated in the schematic view of Fig. 3.

Furthermore, the different modules may be incorporated by software or hardware or by a combination of software and hardware.

The navigation system furthermore comprises a decompression unit which decompresses the navigation data stored in database 310 before they can be used by the route calculation unit or before they can be displayed on display 340. The decompression unit replaces in the compressed blocks 122a, 122b the references by the substrings stored in the corresponding seed blocks 121a, 121b.

In other words for the decompression the seed block or substring block is used as a virtual prefix of the compressed data block when it has been stored with the seed block as virtual prefix. As can be also seen from the above said, the decompression of the navigation map data is not possible without the seed block. This means that the use of a seed block and the compressed block for the different functional blocks provides an encryption to the data as the navigation data cannot be used without the corresponding seed blocks. When the decompression unit 350 has decompressed a block by replacing all the references by the corresponding substrings, the uncompressed navigation map data can then be used by the route calculation unit and by other modules of the navigation system.

A first encryption is obtained when the seed block is stored separate from the compressed blocks. Furthermore it is possible to store the seed block or seed blocks together with the compressed blocks and to encrypt the seed blocks using known encryption methods such as AES (Advanced Encryption Standard) or RSA (Rivest Shamir and Adleman Encryption).

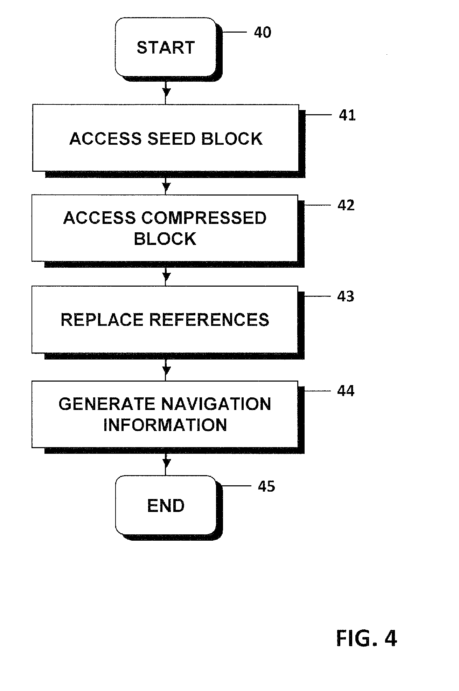

In Fig. 4 the different steps for decompression are summarized. The method starts in step 40 and in step 41 a seed block is accessed, and the compressed block is accessed in step 42. In each compressed block the substrings that were replaced by a reference are identified in the corresponding seed block and the replaced substring is again introduced into the compressed block in order to generate the uncompressed block (step 43). Based on the uncompressed navigation map data the navigation information to be output to the user can be generated in step 44. The method ends in step 45.

As can be seen from the above said, the invention provides an efficient compression of navigation map data. At the same time the compression method provides an encryption of the data, as the navigation map data cannot be used without the corresponding seed blocks. In order to improve the encryption, the information provided in a seed block may furthermore be encrypted using known encryption methods.

## Claims

1. A method for generating a compressed navigation map database from uncompressed navigation map data, the uncompressed navigation map data containing different building blocks (111) of navigation data, each building block addressing a specific functional aspect of the navigation data, each block containing strings of data, the method comprising the steps of:
- determining, for the building blocks of the uncompressed navigation map data, most frequent substrings contained in the building blocks,
- storing, for the building blocks, the determined most frequent substrings in at least one seed block (121),
- replacing, in the building blocks, in the strings the determined most frequent substrings stored in said at least one seed block (121) by a reference to said at least one seed block thereby generating a compressed block (122) for each building block,
- storing the compressed blocks (122) and said at least one seed block (121) in order to generate the compressed navigation map database.

2. The method according to claim 1, wherein the replaced reference contains an offset information and a length information , the offset information indicating where in the seed block the replaced most frequent substring is located, the length information indicating the length of the replaced most frequent substring.

3. The method according to claim 1 or 2, wherein the most frequent substring of a block is generated by determining a prefix tree of said block and by determining the most frequent substrings in the prefix tree.

4. The method according to any one of the preceding claims, wherein the uncompressed navigation map data contain at least one of the following blocks: a routing building block, a name building block, a traffic information building block, a 3d object building block, a junction view building block, digital terrain building block.

5. The method according to any of the preceding claims, wherein the most frequent substrings of a plurality of building blocks are stored in one seed block.

6. The method according to any one of claims 1-4, wherein a seed block containing the most frequent substrings is determined for each building block.

7. The method according to any one of the preceding claims, wherein each building block is separated into parts before compression, wherein the most frequent substrings are determined for each part of a building block, the most frequent substrings of the different parts of a building block being stored in one seed block.

8. A compression module configured to generate a compressed navigation map database, the module comprising:
- a first database (110) containing uncompressed navigation map data, the uncompressed navigation map data containing different building blocks (111) of navigation data, each building block addressing a specific functional aspect of the navigation map data, each building block containing strings of data,
- a second database (120),
- a processing unit (100) configured to determine, for the building blocks (111) of the uncompressed navigation map data, most frequent substrings of the building blocks, configured to store, for the building blocks, the determined most frequent substrings of the building blocks in at least one seed block (121), configured to replace, for the building blocks, in the strings the determined most frequent substrings stored in said at least one seed block by a reference to said at least one seed block (121) thereby generating a compressed block (122) for each building block, and configured to store in the second database (122) the compressed blocks (122) and said at least one seed block (121) in order to generate the compressed navigation map database.

9. The compression module according to claim 8, wherein the processing unit (100) is configured to include in the replaced reference an offset information and a length information, the offset information indicating where in the seed block the replaced most frequent substring is located, the length information indicating the length of the replaced most frequent substring.

10. The compression module according to claim 8 or 9, wherein the processing unit (100) is configured to determine the most frequent substrings of a block by generating a prefix tree of said block and by determining the most frequent substrings in the prefix tree.

11. A navigation system (300) providing navigation information to a user, the system comprising:
- a storage unit (310) containing a navigation map database of compressed navigation map data, the compressed navigation data containing different building blocks of navigation data, each building block addressing a specific functional aspect of the navigation data, each building block containing strings of data, the map database containing at least one seed block (121) and compressed blocks (122), the seed block (121) containing the most frequent substrings of at least one building block, wherein in the compressed blocks (122) the determined most frequent substrings stored in said at least one seed block (121) are replaced by a reference to said at least one seed block,
- an information unit (340) providing the navigation information to the user,
- a decompression unit (350) configured to generate uncompressed navigation map data from the compressed navigation map data, wherein the decompression unit (350) is configured to access the compressed blocks (122) and said at least one seed block (121), to replace the references contained in the compressed blocks (122) by the corresponding most frequent substring stored in said at least one seed block (121) in order to generate the uncompressed navigation map data, and configured to generate the navigation information based on the uncompressed navigation map data wherein the information unit (340) uses the uncompressed navigation map data to provide the navigation information to the user.

12. A method for providing navigation information to a user, the method comprising the steps of:
- generating uncompressed navigation map data from compressed navigation map data, the compressed navigation map data containing different building blocks of navigation map data, each building block addressing a specific functional aspect of the navigation map data, each building block containing strings of data, the compressed navigation data containing at least one seed block (121) and the compressed blocks (122), said at least one seed block (121) containing the most frequent substrings of the building blocks, wherein in the compressed block (122) the determined most frequent substrings stored in said at least one seed block are replaced by a reference to said at least one seed block (121), wherein the uncompressed navigation data are generated by accessing the compressed blocks (122) and said at least one seed block (121), by replacing the references contained in the compressed blocks by the corresponding most frequent substring stored in said at least one seed block in order to generate the uncompressed navigation map data,
- generating the navigation information based on the uncompressed navigation map data and providing the navigation information to the user based on the uncompressed navigation map data.
